# EUROPÄISCHE PATENTANMELDUNG

(11) **EP 0 827 281 A2**
(43) Veröffentlichungstag der Anmeldung: **04.03.1998**
(21) Anmeldenummer: 97202577.9
(22) Anmeldetag: 21.08.1997
(51) Int. Cl.: H03K 17/62

(54) **Schaltungsanordnung mit wenigstens zwei Signalpfaden**

(30) Priorität: 30.08.1996 DE 19635050
(71) Anmelder: Philips Patentverwaltung GmbH, 22335 Hamburg (DE); Philips Electronics N.V., 5621 BA Eindhoven (NL)
(72) Erfinder: Schillhof, Udo, Röntgenstrasse 24, 22335 Hamburg (DE); Graffenberger, Wilhelm, Röntgenstrasse 24, 22335 Hamburg (DE)
(74) Vertreter: Peters, Carl Heinrich, Dipl.-Ing.

(57) **Zusammenfassung**

Beschrieben wird eine Schaltungsanordnung mit wenigstens zwei Signalpfaden, die durch je eine steuerbare Stromquelle zu speisen und durch jeweils eine der steuerbaren Stromquellen auswählende Logiksignale wechselweise wirksam zu schalten sind, wobei beim Übergang von einem Signalpfad auf einen anderen während eines Übergangsintervalls die steuerbaren Stromquellen der betreffenden zwei Signalpfade durch ein zeitlich stetig sich änderndes Steuersignal derart zu steuern sind, daß sich von diesen beiden steuerbaren Stromquellen abgebbare Ströme stetig und gegensinnig ändern.

Das Ziel, diese Schaltungsanordnung so auszubilden, daß der Schaltungsaufwand für eine Einrichtung, mit der ein allmählicher Übergang von einer Einstellposition zur nächsten erreicht wird, spürbar verringert ist, wird erreicht durch eine Ansteuerschaltung (1), die zu jedem der Signalpfade (T18,T19; T28,T29; T38,T39; T48,T49; T58,T59) eine Steuerstufe (11; 21; 31; 41; 51) umfaßt, wobei jede der Steuerstufen (11; 21; 31; 41; 51) enthält:
- einen analogen Multiplexerzweig (T11,R1; T21,R2), über den ein die dem betreffenden Signalpfad (T18,T19; T28,T29; T38,T39; T48,T49; T58,T59) zugehörige steuerbare Stromquelle (I1; I2; I3; I4; I5) wirksam schaltender Strom aus einer von der Ansteuerschaltung (1) umfaßten, den Multiplexerzweigen (T11,R1; T21,R2) aller Steuerstufen (11; 21; 31; 41; 51) gemeinsamen Referenzstromquelle (Iref) leitbar ist,
- eine bistabile Stufe (T14,T16,I11,I12; T24,T26,I21,I22) zum stetigen Steuern des Stromes im Multiplexerzweig (T11,R1; T21,R2) nach Maßgabe des Steuersignals (UTR) und zum Speichern des zum Ende des Übergangsintervalls (t3 - t5) erreichten Betriebszustandes des Multiplexerzweiges (T11,R1; T21,R2) außerhalb des Übergangsintervalls (t3 - t5),
- sowie eine Schaltstufe (I13,T15; I23,T25) zum Aufschalten des Steuersignals (UTR) während des Übergangsintervalls (t3 - t5) mittels der Logiksignale (s1; s2; s3; s4; s5) über die bistabile Stufe (T14,T16,I11,I12; T24,T26,I21,I22) auf den Multiplexerzweig (T11,R1; T21,R2) desjenigen Signalpfades (T18,T19; T28,T29; T38,T39; T48,T49; bzw. T58,T59), der nach Ablauf (t5) des Übergangsintervalls t3 bis t5) nach Maßgabe der Logiksignale (s1; s2; s3; s4; s5) wirksam zu schalten ist.

## Beschreibung

Die Erfindung bezieht sich auf eine Schaltungsanordnung mit wenigstens zwei Signalpfaden, die durch je eine steuerbare Stromquelle zu speisen und durch jeweils eine der steuerbaren Stromquellen auswählende Logiksignale wechselweise wirksam zu schalten sind, wobei beim Übergang von einem Signalpfad auf einen anderen während eines Übergangsintervalls die steuerbaren Stromquellen der betreffenden zwei Signalpfade durch ein zeitlich stetig sich änderndes Steuersignal derart zu steuern sind, daß sich von diesen beiden steuerbaren Stromquellen abgebbare Ströme stetig und gegensinnig ändern.

Aus der DE-OS 32 00 071 ist eine Signalübertragungsvorrichtung mit einer in Schritten einstellbaren Übertragungskennlinie bekannt, die wenigstens eine Gruppe steuerbarer Schalter zum Hindurchleiten eines Signals an unterschiedlichen Eingängen zu einem Ausgang enthält. Darin sind Steuermittel vorhanden, mit deren Hilfe jeweils einer dieser Schalter in den leitenden Zustand geschaltet wird, wobei diese Schalter mittels eines Steuersignals in den leitenden Zustand und aus diesem Zustand geschaltet werden können. Es ist ein Steuersignalgenerator vorhanden zum Erzeugen eines ersten sich zeitlich gleichmäßig ändernden Steuersignals, mit dessen Hilfe ein bestimmter Schalter aus der Gruppe steuerbarer Schalter allmählich in den leitenden Zustand gesteuert wird, und weiterhin zum Erzeugen eines zweiten zu dem ersten Steuersignal komplementären Steuersignals, mit dessen Hilfe zugleich ein anderer Schalter aus der genannten Gruppe steuerbarer Schalter gleichmäßig aus dem leitenden Zustand gesteuert wird.

Aus der DE-OS 32 22 607 ist eine Schaltungsanordnung mit mehreren, durch aktive Schaltungen gebildeten Signalpfaden bekannt. Über diese Signalpfade werden Signale mit unterschiedlichen Pegeln einem gemeinsamen Ausgang zugeführt. Die Signalpfade sind durch je eine schaltbare Stromquelle aktivierbar. Jede Stromquelle wird dabei durch wenigstens ein I²L-Gatter gebildet. Diese Gatter sind in eine erste und eine zweite Gruppe eingeteilt, wobei die Injektoranschlüsse der ersten Gruppe mit einem ersten Sammelpunkt und die Injektoranschlüsse der zweiten Gruppe mit einem zweiten Sammelpunkt verbunden sind. Die Steuereingänge der I²L-Gatter sind so gesteuert, daß beim Übergang von einem Signalpfad auf einen anderen zwei zu je einem der Signalpfade und zu je einer der Gruppen gehörende I²L-Gatter zumindest während einer Übergangsphase Strom führen können. Die Sammelpunkte sind derart gewählt, daß während der Übergangsphase sich die Ausgangsströme der beiden I²L-Gatter kontinuierlich und gegensinnig ändern.

Bei diesen bekannten Schaltungsanordnungen wird der Übergang von einer Einstellposition zur nächsten über eine vorgegebene Zeit gedehnt und verrundet. Dadurch werden beim Stellvorgang auftretende Störgeräusche, die von Arbeitspunkrverschiebungen, Spannungsimpulsen und Modulationseffekten herrühren, reduziert. Insbesondere können damit bei einer Anwendung auf Audiosignale hörbare Signalstörungen unterdrückt werden.

Es hat sich jedoch gezeigt, daß der Schaltungsaufwand für eine praktische Ausführung der beschriebenen Schaltungsanordnungen verhältnismäßig hoch ist.

Die Erfindung hat die Aufgabe, eine Schaltungsanordnung der gattungsgemäßen Art so auszubilden, daß der Schaltungsaufwand für eine Einrichtung, mit der ein allmählicher Übergang von einer Einstellposition zur nächsten erreicht wird, spürbar verringert ist.

Erfindungsgemäß wird diese Aufgabe bei einer Schaltungsanordnung der gattungsgemäßen Art gelöst durch eine Ansteuerschaltung, die zu jedem der Signalpfade eine Steuerstufe umfaßt, wobei jede der Steuerstufen enthält:
- einen analogen Multiplexerzweig, über den ein die dem betreffenden Signalpfad zugehörige steuerbare Stromquelle wirksam schaltender Strom aus einer von der Ansteuerschaltung umfaßten, den Multiplexerzweigen aller Steuerstufen gemeinsamen Referenzstromquelle leitbar ist,
- eine bistabile Stufe zum stetigen Steuern des Stromes im Multiplexerzweig nach Maßgabe des Steuersignals (UTR) und zum Speichern des zum Ende des Übergangsintervalls erreichten Betriebszustandes des Multiplexerzweiges außerhalb des Übergangsintervalls,
- sowie eine Schaltstufe zum Aufschalten des Steuersignals während des Übergangsintervalls mittels der Logiksignale über die bistabile Stufe auf den Multiplexerzweig desjenigen Signalpfades, der nach Ablauf des
Übergangsintervalls nach Maßgabe der Logiksignale wirksam zu schalten ist.

Bei der erfindungsgemäßen Schaltungsanordnung kann der Schaltungsaufwand dadurch wesentlich verringert werden, weil anstelle umfangreicher Logikschaltungen die zur Speisung der Signalpfade ohnehin vorhandenen steuerbaren Stromquellen nur durch sehr einfach aufgebaute Steuerstufen ergänzt werden müssen. Diese in der Ansteuerschaltung zusammengefaßten Steuerstufen übernehmen neben der analogen Umblendung von einem Signalpfad auf den nächsten auch die Speicherung des aktuellen Zustandes unabhängig von den Logiksignalen, die lediglich noch den nach der Überblendung einzunehmenden Schaltzustand der Schaltungsanordnung vorgeben müssen. Somit kann durch diese Logiksignale bereits eine neue Stellposition dargestellt und vorbereitet werden, während die Signalpfade durch die erfindungsgemäße Schaltungsanordnung noch im bisherigen Betriebszustand verbleiben. Außerdem wird durch die erfindungsgemäße Schaltungsanordnung in sehr einfacher Weise eine Verzögerung der Umblendung gegenüber der Einstellung der Logiksignale ermöglicht, so daß Laufzeiteffekte, mit denen die Logiksignale behaftet sein können und die sich beispielsweise durch Spannungsspitzen äußern können, wirkungsvoll unterdrückt werden.

In einer vorteilhaften Weiterbildung weist die erfindungsgemäße Schaltungsanordnung das Merkmal auf, daß jede der Steuerstufen eine Sperrstufe umfaßt und daß allen Sperrstufen ein gemeinsames Aktivierungssignal zuleitbar ist, durch das sie während des Übergangsintervalls zum Zuführen der Logiksignale an die Schaltstufen und außerhalb des Übergangsintervalls zum Unterbrechen der Zufuhr der Logiksignale umsteuerbar sind. Die Sperrstufen, die nur während des Übergangsintervalls für die Logiksignale durchlässig sind, verhindern eine Beeinflussung der Signalpfade durch die Logiksignale des Übergangsintervalls. Mit dem die Sperrstufen gemeinsam umsteuernden Aktivierungssignal kann somit einfach und präzise das Einstreuen von Störungen aus Änderungen der Logiksignale außerhalb des Übergangsintervalls über die Steuerstufen in die Signalpfade und damit in ein darin zu führendes Nutzsignal verhindert werden. Derartige Störungen treten besonders durch Laufzeiteffekte als Nadelimpulse auf; werden diese in die Signalpfade übertragen, würde beispielsweise bei Übertragung eines Audiosignals in diesen Signalpfaden im Audiosignal ein störendes Knackgeräusch auftreten. Außerdem erfolgt eine Entkopplung vom Steuersignal, so daß dieses für mehrere Steller-Blöcke gemeinsam verwendet werden kann.

Eine andere Fortbildung der erfindungsgemäßen Schaltungsanordnung zeichnet sich dadurch aus, daß mit jeder Steuerstufe eines der Logiksignale zugeordnet ist und daß dieses Logiksignal einen ersten Signalpegel annimmt, wenn der zugehörige Signalpfad nach Ablauf des nächsten Übergangsintervalls wirksam geschaltet sein soll, während gleichzeitig alle übrigen Logiksignale einen zweiten Signalpegel annehmen. Derartige Logiksignale können bevorzugt aus einer Datenübertragungseinrichtung entnommen werden, die mit einem sogenannten "1 aus n"-Decoder ausgestattet ist. Dann können die Logiksignale in einfacher Weise über einen sogenannten I² C-Bus vorgegeben werden. Dabei lassen sich vorgegebene Signalpegel und eine Leistungsentkopplung von der Datenübertragungseinrichtung vorteilhaft dadurch erreichen, daß jede der Steuerstufen einen Inverter umfaßt zum Zuführen des zugeordneten Logiksignals an die zugehörige Schaltstufe bzw. Sperrstufe.

Die Signalpfade in der erfindungsgemäßen Schaltungsanordnung lassen sich dadurch besonders einfach speisen und steuern, daß die steuerbaren Stromquellen je eine Stromspiegelanordnung umfassen, deren Eingangszweig der die steuerbare Stromquelle wirksam schaltende Strom aus dem zugehörigen Multiplexerzweig zuführbar ist und deren Ausgangszweig den zugehörigen Signalpfad speist

Für eine besonders aufwandsarme Ausführung der erfindungsgemäßen Schaltungsanordnung ist vorgesehen, daß die bistabilen Stufen je einen durch den Eingangszweig der zugehörigen steuerbaren Stromquelle steuerbaren Haltestromzweig umfassen, dem im Fall des Wirksamschaltens des zugehörigen Signalpfades ein Haltestrom zum Speichern des dementsprechenden Betriebszustandes des zugehörigen Multiplexerzweiges entnehmbar ist. Ein derartiger Haltestromzweig kann nämlich durch einen einzigen Transistor, der der Stromspiegelanordnung der betreffenden steuerbaren Stromquelle angefügt ist, gebildet werden. Dieser Haltestromzweig liefert immer dann einen Strom, wenn die mit ihm verbundene steuerbare Stromquelle einen Strom führt. Damit wird der Schaltzustand der zugehörigen bistabilen Stufe unmittelbar aus dem Schaltzustand der steuerbaren Stromquelle abgeleitet, ohne daß umfangreiche logische Schaltkreise erforderlich wären.

In einer vorteilhaften Fortbildung der Erfindung ist vorgesehen, daß die bistabilen Stufen ferner enthalten: Je eine erste Konstantstromquelle die einerseits an ein erstes Bezugspotential und andererseits über ein Potentialschiebeelement an einen Verbindungspunkt mit dem Haltestromzweig angeschlossen ist, und eine zweite Konstantstromquelle, die einerseits an den Verbindungspunkt und andererseits an ein zweites Bezugspotential angeschlossen ist. Dabei ist bevorzugt die erste Konstantstromquelle derart ausgebildet, daß sie den Haltestrom aufnehmen kann. Die zweite Konstantstromquelle ist insbesondere für einen wesentlich kleineren Strom dimensioniert, durch den unter anderem bei gesperrtem Haltestromzweig etwaige Restladungen oder Leckströme abgeführt werden können. Vorzugsweise ist auch das Potentialschiebeelement derart ausgebildet, daß es nur in der Flußrichtung des Haltestromes leitend, in Gegenrichtung jedoch sperrend ist. Dadurch kann bei fehlendem Haltestrom der genannte Verbindungspunkt von der ersten Konstantstromquelle und damit vom ersten Bezugspotential abgetrennt werden, so daß er über die zweite Konstantstromquelle an das zweite Bezugspotential gelegt werden kann. Vorteilhaft ist dabei das erste Bezugspotential höher als das zweite Bezugspotential.

Nach einer anderen Weiterbildung der Erfindung enthalten die Multiplexerzweige je ein Steuerelement, welches einen Steueranschluß aufweist, der mit der zugehörigen bistabilen Stufe verbunden ist. Insbesondere ist dieses Steuerelement von einem Transistor gebildet, dessen Steueranschluß mit dem Verbindungspunkt in der zugehörigen bistabilen Stufe verknüpft ist. Der Multiplexerzweig kann so durch die bistabile Stufe mit Hilfe des ein- bzw. ausgeschalteten Haltestromes und der Bezugspotentiale in die beiden Betriebszustände außerhalb des Übergangsintervalls gesteuert werden.

Die Steuerung der Multiplexerzweige während des Übergangsintervalls wird vorteilhaft dadurch ermöglicht, daß die Schaltstufen je ein Schalterelement enthalten, das einen Steueranschluß aufweist, dem das zugeordnete Logiksignal zuleitbar ist, in welchem Fall das Steuersignal durch das Schalterelement dem Verbindungspunkt der zugehörigen bistabilen Stufe aufgeschaltet wird. Insbesondere weist das Steuersignal während des Übergangsintervalls einen wenigstens nahezu rampenförmigen zeitlichen Verlauf auf. In der dem durch das Logiksignal ausgewählten Signalpfad zugehörigen Steuerstufe erfolgt somit während des Übergangsintervalls eine stetige Umsteuerung des Stromes der zugehörigen steuerbaren Stromquelle. Dabei wird durch das Logiksignal bevorzugt die steuerbare Stromquelle ausgewählt, deren Strom im Übergangsintervall zunehmen soll. Da die Multiplexerzweige der Steuerstufen dieser steuerbaren Stromquelle und der bis zum Beginn des Übergangsintervalls wirksam geschalteten Stromquelle die Referenzstromquelle gemeinsam haben, werden im Übergangsintervall gemäß dem Steuersignal die die genannten steuerbaren Stromquellen wirksam schaltenden Ströme sich stetig gegenläufig ändern, wobei ihre Summe dem durch die Referenzstromquelle fließenden Strom entspricht. Auf sehr einfache Weise kommt somit der gewünschte stetige Übergang von einer steuerbaren Stromquelle auf eine andere und somit von einem Signalpfad auf einen anderen zustande.

Anstelle des rampenförmigen zeitlichen Verlaufes des Steuersignals kann für dieses auch ein anderer, stetiger zeitlicher Verlauf gewählt werden, sofern sich dieses für die Umsteuerung zwischen den Signalpfaden und die daraus resultierende Auswirkung auf ein in den Signalpfaden zu führendes Nutzsignal vorteilhaft ist.

In einer bevorzugten Anwendung der erfindungsgemäßen Schaltungsanordnung umfassen die Signalpfade je eine von der zugehörigen steuerbaren Stromquelle zu speisende Differenzverstärkerstufe, die nur wirksam geschaltet ist, wenn ihr von der steuerbaren Stromquelle ein Strom zugeführt wird. Dabei können insbesondere alle Differenzverstärkerstufen ausgangsseitig mit einer gemeinsamen Ausgangsstufe verbunden sein. Es sei an dieser Stelle bemerkt, daß eine derartige Anordnung von Differenzverstärkerstufen und gemeinsamer Ausgangsstufe an sich aus der DE-OS 43 32 658 bekannt ist.

Die erfindungsgemäße Schaltungsanordnung eignet sich bevorzugt für den Einsatz in einem Signalsteller. Dieser kann vorteilhaft in einem Lautstärke- und/oder Klangeinsteller für ein Audiosignal Verwendung finden, wie er besonders bei Wiedergabegeräten für Audiosignale eingesetzt wird. In diesen Wiedergabegeräten bewirkt die Erfindung eine Reduktion von Störgeräuschen beim Stellvorgang für das Audiosignal mit sehr geringem Schaltungsaufwand. Die Einflüsse von Gleichpegelverschiebungen, Nadelimpulsen oder unerwünschten Modulationen können damit sehr wirkungsvoll unterdrückt werden. Durch die aufwandsarme, erfindungsgemäße Schaltungsanordnung wird es ermöglicht, ein entsprechend störungsarmes Audiosignal auch in einfachen, preiswerten Wiedergabegeräten zu erzeugen.

Ausführungsbeispiele der Erfindung sind in der Zeichnung dargestellt, wobei einander entsprechende Elemente in den verschiedenen Figuren mit denselben Bezugszeichen versehen sind. Es zeigen
- Fig. 1: ein Beispiel für eine Anordnung mit mehreren Signalpfaden zur Verwendung mit der vorliegenden Erfindung,
- Fig. 2: eine Datenübertragungseinrichtung zur Verwendung mit der vorliegenden Erfindung,
- Fig. 3: ein erstes Beispiel für eine Ansteuerschaltung gemäß der Erfindung,
- Fig. 4 und 5: Signalverläufe für zwei Ausführungsbeispiele der Erfindung,
- Fig. 6: ein zweites Ausführungsbeispiel der erfindungsgemäßen Schaltungsanordnung.

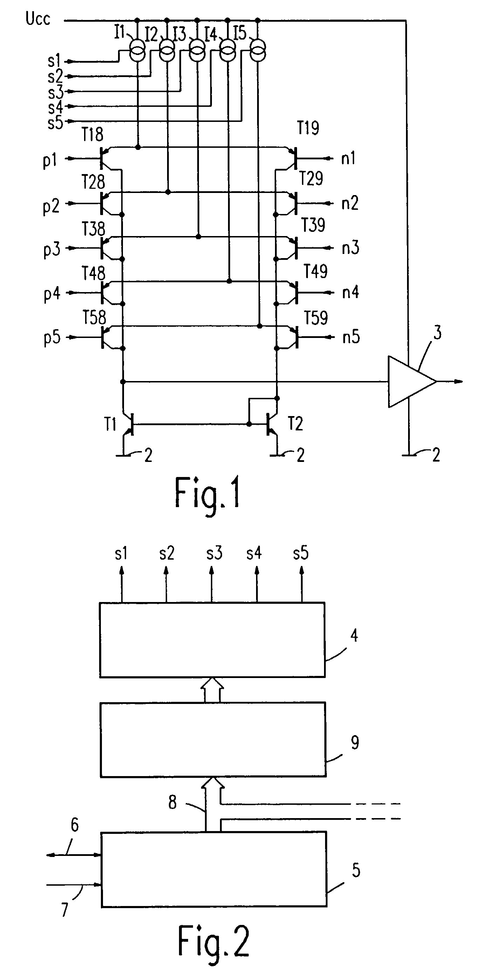

Fig. 1 zeigt einen Operationsverstärker, der als Beispiel fünf verschiedene Signalpfade zur Verfügung stellen kann. Jeder dieser Signalpfade wird durch eine Differenzverstärkerstufe aus zwei emittergekoppelten Transistoren vom PNP-Typ gebildet. Dabei umfaßt der erste Signalpfad die Transistoren T18, T19, der zweite Signalpfad die Transistoren T28, T29, der dritte Signalpfad die Transistoren T38, T39, der vierte Signalpfad die Transistoren T48, T49 und der fünfte Signalpfad die Transistoren T58, T59. Die gekoppelten Emitter jedes dieser Transistorenpaare sind über je eine (erste, zweite, dritte, vierte bzw. fünfte) Stromquelle I1, I2, I3, I4 bzw. I5 mit einer Versorgungsspannung Ucc verbunden. Die Basisanschlüsse der jeweils ersten Transistoren der Signalpfade T18, T28, T38, T48 bzw. T58 bilden jeweils einen positiven Signaleingang p1, p2, p3, p4 bzw. p5 des ersten, zweiten, dritten, vierten bzw. fünften Signalpfades. Entsprechend bilden die Basisanschlüsse des jeweils zweiten Transistors T19, T29, T39, T49 bzw. T59 je einen negativen Signaleingang n1, n2, n3, n4 bzw. n5 des ersten, zweiten, dritten, vierten bzw. fünften Signalpfades. Die Kollektoren aller ersten Transistoren T18, T28, T38, T48, T58 aller Signalpfade sind untereinander und mit dem Kollektor eines Ausgangstransistors T1 eines Eingangsstromspiegels sowie einem Eingang einer gemeinsamen Ausgangsstufe 3 aller Signalpfade T18, usw. verbunden. Entsprechend sind die Kollektoren der jeweils zweiten Transistoren T19, T29, T39, T49 und T59 aller Signalpfade miteinander und mit dem Kollektor und der Basis eines Eingangstransistors T2 des Eingangsstromspiegels der gemeinsamen Ausgangsstufe 3 aller Signalpfade T18, usw. verbunden. Die Emitteranschlüsse des Eingangstransistors T2 und des Ausgangstransistors T1 des Eingangsstromspiegels zur gemeinsamen Ausgangsstufe 3 sind mit einem zweiten Bezugspotential 2, im vorliegenden Beispiel Masse, verbunden. Auch die gemeinsame Ausgangsstufe 3 ist mit der Versorgungsspannung Ucc und Masse 2 verbunden. Über die Signaleingänge n1, p1, bis n5, p5 der Signalpfade können diesen verschiedene Nutzsignale, beispielsweise Audiosignale zugeleitet werden. Diese Nutzsignale werden jedoch nur von denjenigen der Signalpfade an den Eingangsstromspiegel T1, T2 weitergeleitet, deren zugehörige steuerbaren Stromquellen I1 bis I5 wirksam geschaltet sind, d.h. einen Strom zur Speisung der entsprechenden Differenzverstärkerstufe liefern. Die steuerbaren Stromquellen I1 bis I5 werden durch ein erstes, zweites, drittes, viertes bzw. fünftes Logiksignal s1, s2, s3, s4 bzw. s5 wirksam geschaltet. In der üblichen Betriebsart der Anordnung nach Fig. 1 werden die Logiksignale s1 bis s5 derart gewählt, daß nur jeweils eine der steuerbaren Stromquellen I1 bis 5 wirksam geschaltet ist. Das Nutzsignal vom zugehörigen Signaleingang n1, p1, bis n5, p5 wird dann vom Ausgang Aus der gemeinsamen Ausgangsstufe aller Signalpfade abgegeben.

Eine derartige Operationsverstärkeranordnung, die im Prinzip aus der DE-OS 43 32 658 bekannt ist, kann bevorzugt mit Logiksignalen s1 bis s5 gesteuert werden, wie sie beispielsweise aus einer Schaltungsanordnung gemäß Fig. 2 abgeleitet werden können. Diese in Fig. 2 dargestellte Datenübertragungseinrichtung ist insbesondere dazu eingerichtet, die Logiksignale s1 bis s5 aus einem sogenannten I² C-Bus abzuleiten. Dazu umfaßt die Datenübertragungseinrichtung nach Fig. 2 eine sogenannte Interface-Schaltung 5, der über eine Datenleitung 6 daten in serieller Form zugeführt werden. Das im Rahmen des sogenannten I² C-Bus-Protokolls auf der Datenleitung 6 auch Daten in serieller Form von der Interface-Schaltung abgegeben werden können, ist für die Betrachtung der vorliegenden Erfindung von untergeordneter Bedeutung. Außerdem weist die Interface-Schaltung 5 eine Taktleitung 7 zum Zuführen eines Taktsignals in serieller Form auf, durch das die Übertragung der Daten auf der Datenleitung 6 gesteuert wird. Die interface-Schaltung 5 wandelt die Daten aus der seriellen Form in eine parallele Form um und gibt sie über eine Leitung 8 in einen Speicher 9. Vom Speicher 9 gelangen die gespeicherten Daten an einen " 1 aus n"-Decoder, der daraus die Logiksignale s1 bis s5 erzeugt und über entsprechende Ausgänge zur Verfügung stellt.

Beim Betrieb des Operationsverstärkers nach Fig. 1 mit einer Datenübertragungseinrichtung nach Fig. 2 wird für jeden Betriebszustand des Operationsverstärkers, d.h. für jeden Betriebszustand seiner Signalpfade, ein entsprechender Satz Daten im Speicher 9 abgelegt und für die Dauer der Beibehaltung dieses Betriebszustandes auch im Speicher 9 gehalten. Werden über die Datenleitung 6 Daten für einen neuen Betriebszustand übertragen, schaltet sich der Operationsverstärker nach Fig. 1 in diesen um, sobald die Daten in den Speicher 9 gelangt sind, dort die Daten für den vorherigen Betriebszustand des Operationsverstärkers überschrieben haben und entsprechende Logiksignale s1 bis s5 durch den "1 aus n"-Decoder erzeugt worden sind. Dabei wird ein abrupter, störungsbehafteter Übergang der Betriebszustände des Operationsverstärkers erhalten.

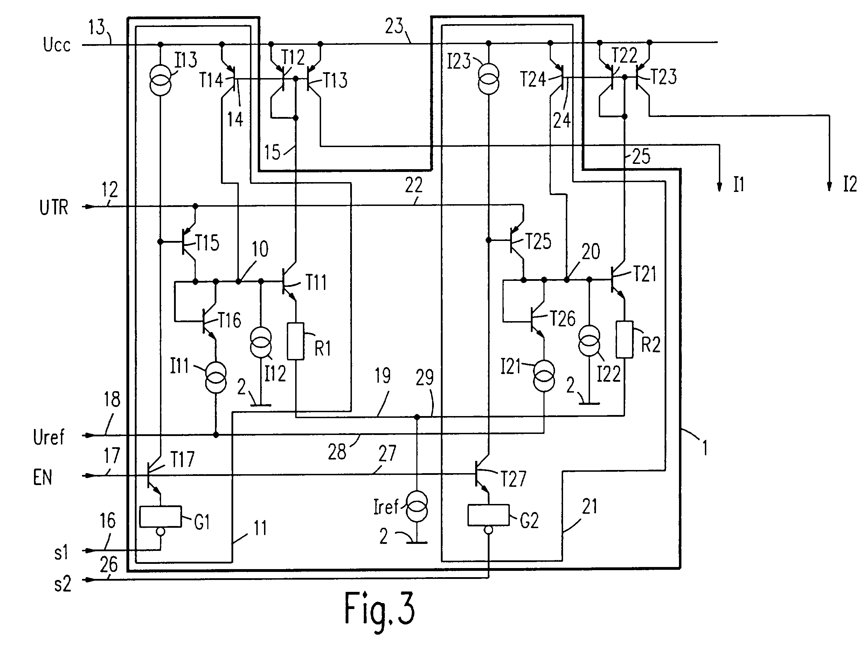

Um anstelle dieses abrupten, störungsbehafteten Übergangs zwischen den Betriebszuständen des Operationsverstärkers nach Fig. 1, d.h. bei der Umschaltung zwischen zwei Signalpfaden, mit geringem Schaltungsaufwand einen störungsfreien Übergang zu erhalten, wird in die Verbindungen für die Logiksignale s1, usw. erfindungsgemäß eine Ansteuerschaltung eingefügt, wie sie an einem Beispiel für zwei Signalpfade in Fig. 3 dargestellt und mit dem Bezugszeichen 1 versehen ist. Die Ansteuerschaltung 1 nach Fig. 3 umfaßt eine erste Steuerstufe 11, eine zweite Steuerstufe 21 sowie eine gemeinsame Referenzstromquelle Iref. Dabei ist die Dimensionierung der Referenzstromquelle Iref zumindest im wesentlichen von der Anzahl der Steuerstufen 11, 21 in der Ansteuerschaltung 1 unabhängig, was sich einerseits günstig auf den Stromverbrauch einer für eine größere Anzähl von Signalpfaden ausgelegten Ansteuerschaltung 1 auswirkt und andererseits deren Dimensionierung erleichtert.

Die Ansteuerschaltung 1 weist einen Signaleingang 16 bzw. 26 für das erste bzw. das zweite Logiksignal s1 bzw. s2 auf. Über je einen Ausgang 15 bzw. 25 sind die Steuerstufen 11 bzw. 21 mit den zugehörigen steuerbaren Stromquellen I1 bzw. I2 verbunden, die in Fig. 3 durch je eine Stromspiegelanordnung gebildet werden. Dabei umfaßt die Stromspiegelanordnung der ersten steuerbaren Stromquelle I1 als Eingangszweig einen Transistor T12 und als Ausgangszweig einen Transistor T13; entsprechend enthält die Stromspiegelanordnung der zweiten steuerbaren Stromquelle I1 einen Transistor T22 als Eingangszweig und einen weiteren Transistor T23 als Ausgangszweig. Die Transistoren T12, T13 sind mit ihren Basisanschlüssen miteinander und mit dem Kollektor des Transistors T12 des Eingangszweiges verbunden; eine entsprechende Verbindung besteht auch für die Transistoren T22, T23 der Stromspiegelanordnung der zweiten steuerbaren Stromquelle untereinander. Alle Transistoren T12, T13, T22, T23 sind vom PNP-Typ und mit ihren Emittern mit der Versorgungsspannung Ucc verbunden. Den Kollektoren der Transistoren T13 bzw. T23 der Ausgangszweige werden die Ströme der Stromquellen I1 bzw. I2 zur Speisung der differenzverstärkerstufen T18, usw. entnommen. Die Eingangszweige T12 bzw. T22 sind an Ausgänge 15 bzw. 25 bzw. der zweiten Steuerstufe 11 bzw. 21 angeschlossen. Die steuerbaren Stromquellen I1, I2 werden über diese Ausgänge 15, 25 anstelle unmittelbar durch die Logiksignale s1, s2 wirksam geschaltet. Die erste Steuerstufe 11 enthält einen ersten analogen Multiplexerzweig aus einem ein Steuerelement bildenden Transistor T11 und einem Emitterwiderstand R1. Das Steuerelement T11 ist in Fig. 3 vom NPN-Typ; sein Kollektor bildet den Ausgang 15 des ersten Multiplexerzweiges, und sein Emitter ist über den Emitterwiderstand R1 an einen Anschluß 19 geführt, mit dem die Referenzstromquelle Iref einseitig verbunden ist. In entsprechender Weise enthält die zweite Steuerstufe einen aus einem Steuerelement T 21 und einem Emitterwiderstand R2 bestehenden, zweiten analogen Multiplexerzweig, der zwischen dem Ausgang 25 und einem Anschluß 29 angeordnet ist. Auch der Anschluß 29 ist mit der Referenzstromquelle Iref an derselben Seite wie der erste Multiplexerzweig T11, R1 verbunden; der andere Anschluß der Referenzstromquelle Iref ist an das zweite Bezugspotential (Masse) 2 geführt.

Die erste Steuerstufe 11 enthält ferner eine erste bistabile Stufe aus einer ersten Konstantstromquelle I11, einer zweiten Konstantstromquelle I12, einem Haltestromzweig (Transistor) T14 sowie einem Potentialschiebeelement T16. Der den Haltestromzweig T14 bildende Transistor vom PNP-Typ ist mit seinem Emitter an die Versorgungsspannung Ucc angeschlossen. Der Kollektor des Transistors 14 und ein Anschluß der zweiten Konstantstromquelle I12 sind in einem Verbindungspunkt 10 miteinander verbunden, an den auch das Potentialschiebeelement T16 angeschlossen ist. Dieses besteht in Fig. 3 aus einem NPN-Transistor, dessen Kollektor und dessen Basis an den Verbindungspunkt 10 geführt sind. der Emitter des Potentialschiebeelements T16 ist über die erste Konstantstromquelle I11 an einen Anschluß 18 für ein erstes Bezugspotential Uref geführt, wohingegen die zweite Konstantstromquelle I12 anderseitig an Masse 2 angeschlossen ist. Der Verbindungspunkt 10 ist ferner im Basisanschluß des Steuerelements T11 des ersten Multiplexerzweiges verbunden.

Entsprechend umfaßt die zweite Steuerstufe 21 eine zweite bistabile Stufe aus einer ersten Konstantstromquelle I21 und einer zweiten Konstantstromquelle I22 dieser zweiten bistabilen Stufe, einem Haltestromzweig T24 und einem Potentialschiebeelement T26. die in gleichartiger Weise miteinander und mit dem Basisanschluß des Steuerelements T21 des zweiten analogen Multiplexerzweiges in einem Verbindungspunkt 20 verbunden sind.

Die Verbindung der ersten bzw. zweiten Steuerstufe 11 bzw. 21 mit der Versorgungsspannung Ucc erfolgt über einen Versorgungsspannungsanschluß 13 bzw. 23. Die Basisanschlüsse der Haltestromzweige T14 bzw. T24 sind über je einen Haltestrom-Steueranschluß 14 bzw. 24 der ersten bzw. zweiten Steuerstufe 11 bzw. 21 mit dem zugehörigen Ausgang 15 bzw. 25 des ersten bzw. zweiten Multiplexerzweiges in der Weise verbunden, daß die Haltestromzweige T14 bzw. T24 gemeinsam mit den Eingangszweigen T12 bzw. T22 der steuerbaren Stromquellen I1 bzw. I2 gesteuert werden.

Weiterhin enthält die erste Steuerstufe 11 eine erste Schaltstufe aus einer dritten Konstantstromquelle 13 und einem Schalterelement T15. welches als PNP-Transistor ausgebildet ist. Die dritte Konstantstromquelle I13 der ersten Schaltstufe ist einerseits mit der Versorgungsspannung Ucc über den Versorgungsspannungsanschluß 13 und andererseits mit dem Basisanschluß des das Schalterelement bildenden Transistors T15 verbunden. Der Kollektor des Transistors 15 ist an den Verbindungspunkt 10 geführt.

Entsprechend angeschlossen bilden in der zweiten Steuerstufe 21 eine dritte Konstantstromquelle I23 der zweiten Steuerstufe sowie ein Schalterelement T25 eine zweite Schaltstufe, die entsprechend an den Versorgungsspannungsanschluß 23 der zweiten Steuerstufe 21 bzw. an den dortigen Verbindungspunkt 20 angeschlossen ist.

Vom Basisanschluß des Schalterelements T15 besteht eine Verbindung der ersten Schaltstufe zum Logiksignaleingang 16 der ersten Steuerstufe. Im Beispiel nach Fig. 3 ist diese Verbindung über eine Sperrstufe 17 und einen Inverter G1 hergestellt. Die Sperrstufe besteht aus einem NPN-Transistor, dessen Kollektor mit dem Basisanschluß des Transistors T15 (Schalterelement) und dessen Emitter mit dem Ausgang des Inverters G1 verbunden ist. Der Basisanschluß des die Sperrstufe bildenden Transistors T17 bildet einen Aktivierungssignaleingang 17 der ersten Steuerstufe 11.

In entsprechender Anordnung enthält die zweite Steuerstufe 21 eine Sperrstufe T27 und einen Inverter G2. Der Basisanschluß der Sperrstufe T27 bildet einen Aktivierungssignaleingang 27 der zweiten Steuerstufe 21, der mit dem Aktivierungssignaleingang 17 der ersten Steuerstufe 11 verbunden ist.

In zur ersten Steuerstufe 11 entsprechender Weise wird der zweiten Steuerstufe 21 über einen Anschluß 28 das erste Bezugspotential Uref zugeleitet.

Die Emitter der Schalterelemente T15 bzw. T25 bilden Steuersignaleingänge 12 bzw. 22 der ersten bzw. zweiten Steuerstufe 11 bzw. 21 zum Zuführen eines Steuersignals UTR. Den Aktivierungssignaleingängen 17 und 27 wird im Betrieb das Aktivierungssignal EN zugeleitet.

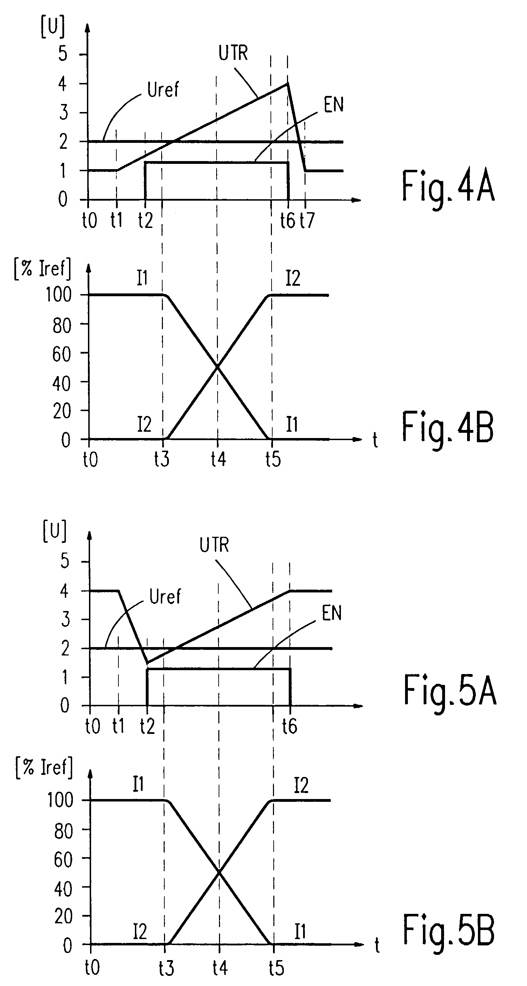

Die Funktion der Schaltungsanordnung nach Fig. 3 wird im folgenden anhand der Diagramme der Fig. 4 näher erläutert. Darin sind in Fig. 4a verschiedene Signale auf einer Spannungsachse U über der Zeit t dargestellt. Dazu zeigt Fig. 4b die Änderungen der Ströme aus den steuerbaren Stromquellen I1 und I2 im Bereich des Übergangsintervalls.

Für die Erklärung der Funktion der Ansteuerschaltung 1 gemäß Fig. 3 wird angenommen, daß zum Zeitpunkt t0 ein "Ruhezustand" vorliegt, d.h. der erste Signalpfad T18, T19 mit der ersten steuerbaren Stromquelle I1 ist wirksam geschaltet während alle übrigen Signalpfade, d.h. in Fig. 3 die zweite steuerbare Stromquelle I2, unwirksam geschaltet sind. Dieser Betriebszustand sei kontinuierlich bis zum Zeitpunkt t0 gehalten worden. Das erste Logiksignal s1 nimmt dabei einen hohen Signalpegel als ersten Signalpegel an, hingegen das zweite Logiksignal s2 (und ggf. weitere Logiksignale für weitere Steuerstufen) als zweiten Signalpegel einen niedrigen Signalpegel annehmen. Da sich jedoch das gemeinsame Aktivierungssignal EN bis zum Zeitpunkt t0 auf niedrigem Signalpegel befindet und somit über die Sperrstufen T17 bzw. T27 die Weiterleitung der Logiksignale s1, s2 unterbricht, hat deren Wert bzw. auch deren zeitliche Änderung außerhalb des Übergangsintervalls keinen Einfluß auf den Betriebszustand der Ansteuerschaltung 1. Auch das Steuersignal UTR nimmt einen niedrigen Wert an. Zu dessen Verdeutlichung kann die Skalierung der Spannungsachse U im Diagramm nach Fig. 4a in der Maßeinheit Volt vorgenommen sein; beispielsweise nimmt dann das Steuersignal UTR außerhalb des Übergangsintervalls eine Spannung von 1 V an. Ferner ist in diesem Beispiel nach Fig. 4a das erste Bezugspotential Uref auf zwei Volt festgesetzt; alle Spannungen sind dabei gegenüber dem zweiten Bezugspotential 2 (Masse) angegeben. Die Versorgungsspannung Ucc kann beispielsweise fünf Volt betragen.

In diesem Betriebszustand werden die Schalterelemente T15, T25 der Steuerstufen 11, 21 durch die dritten Konstantstromquellen I13 bzw. I23 der ersten bzw. der zweiten Schaltstufe gesperrt, so daß auch das Steuersignal UTR auf keine der beiden Steuerstufen 11, 21 in Fig. 3 Einfluß ausüben kann. In der ersten Steuerstufe 11 der zu dem Zeitpunkt t0 wirksam geschalteten ersten steuerbaren Stromquelle I1 fließt vom Eingangszweig T12 in den Ausgang 15 des ersten Multiplexerzweiges und damit über den Kollektor und den Emitter des Steuerelements T11 und den Emitterwiderstand R1 der die erste steuerbare Stromquelle wirksam schaltende Strom, der über den Anschluß an die Referenzstromquelle Iref gelangt. Durch den Eingangszweig T12 über den Haltestrom-Steueranschluß 14 gesteuert, führt auch der Haltestromzweig T14 der ersten Steuerstufe 11 einen Strom der dem Verbindungspunkt 10 zugeführt wird und sich über das Potentialschiebeelement T16 mit der ersten Konstantstromquelle I11 der ersten bistabilen Stufe sowie deren zweite Konstantstromquelle I12 und den Basisanschluß des Steuerelements T11 verteilt. Dieser Haltestrom vom Haltestromzweig T14 hält die erste bistabile Stufe I11, I12, T14, T16 und damit das Steuerelement T11 im beschriebenen Betriebszustand unabhängig insbesondere von den Logiksignalen S1 S2 oder auch unabhängig vom Steuersignal UTR. Der von der ersten Konstantstromquelle I11 verfügbare Strom ist dabei derart dimensioniert, daß er größer ist als der von der Referenzstromquelle Iref gelieferte Strom und damit auch größer als der über den Haltestromzweig T14 maximal lieferbare Strom. Dagegen ist der über die zweite Konstantstromquelle I12 verfügbare Strom sehr klein im Vergleich zum Strom der Referenzstromquelle Iref dimensioniert, so daß er in dem vorbeschriebenen Betriebszustand der ersten Steuerstufe 11 vernachlässigbar ist. Daraus ergibt sich, daß die erste Konstantstromquelle I11 zunächst in der Sättigung bleibt. Der Basisanschluß des Steuerelements T11 ist dadurch über den als Diode geschalteten Transistor T16, der das Potentialschibeelement bildet und die erste Konstantstromquelle I11 auf ein Potential geklemmt, welches durch das erste Bezugspotential Uref und die Spannung am Potentialschiebeelement T16 bestimmt ist. Im vorliegenden Beispiel ist dieses Potential etwa 0,7 V höher als das erste Bezugspotential Uref, beträgt also z.B. etwa 2,7 V.

In der zweiten Steuerstufe 21 sind dagegen die zweite steuerbare Stromquelle I2 und damit der mit ihr verbundene Haltestromzweig T24 gesperrt. Durch die erste Konstantstromquelle I21 und die zweite Konstantstromquelle I22 der zweiten bistabilen Stufe der zweiten Steuerstufe 21 wird das Potentialschiebeelement G26 einerseits und das Steuerelement T21 des zweiten analogen Multiplexerzweiges andererseits gesperrt. Der gesperrte Zustand des Steuerelements T21 wird auch dadurch unterstützt, daß am Anschluß 29 für die Referenzstromquelle Iref ein gegenüber Masse 2 positives Potential vorhanden ist.

Für die Erklärung der Funktion der Ansteuerstufe nach Fig. 3 sei nun angenommen, daß im Verlauf des Übergangsintervalls die erste steuerbare Stromquelle und damit der von ihr gespeiste erste signalpfad unwirksam geschaltet werden soll, wohingegen der zweite Signalpfad über die zweite steuerbare Stromquelle I2 wirksam geschaltet werden soll. Dazu werden vor Beginn des Übergangsintervalls, vorzugsweise aber bis zu einem Zeitpunkt t1 im Diagramm nach Fig. 4, in der Datenübertragungseinrichtung gemäß Fig. 2 von der Datenleitung 6 die für die Erzeugung der entsprechenden Logiksignale s1, s2 benötigten Daten in serieller Form aufgenommen und die daraus gebildeten Logiksignale s1, s2 (und ggf. weitere) an den zugehörigen Ausgängen des "1 aus n"-Decoders 4 bereitgestellt. Dabei muß während dieser Bereitstellung, d.h. für in der Regel dazu nötige Umschaltvorgänge der Logiksignale, auf deren zeitlichen Verlauf keine besondere Sorgfalt verwendet werden, da sich die Logiksignale zu diesem Zeitpunkt noch nicht auf die Signalpfade auswirken. Für das vorliegende Beispiel nimmt nach Beendigung der vorstehend genannten Umschaltvorgänge das zweite Logiksignal s2 den ersten (hohen) Signalpegel an, wohingegen das erste Logiksignal s1 den zweiten (niedrigen) Signalpegel annimmt.

Das Steuersignal UTR, welches bis zum Zeitpunkt t1 einen unveränderten Pegel inne hat, wird ab dem Zeitpunkt t1 kontinuierlich verändert. Im Beispiel nach Fig. 4a ist für das Steuersignal UTR vom Zeitpunkt t1 an ein rampenförmiger Anstieg mit konstanter Steigung vorgesehen. Diese (zeitlich stetige) Änderung des Steuersignals URT wirkt sich jedoch noch nicht auf die Steuerstufen 11, 21 aus, da auch nach dem Zeitpunkt t1 vorerst das Aktivierungssignal EN noch auf niedrigem Signalpegel verbleibt und somit die Schalterelemente T15, T25 weiterhin gesperrt bleiben. Der dargestellte, rampenförmige Verlauf des Steuersignals UTR kann den Steuersignaleingängen 12, 22 von einem nicht dargestellten Dreieckspannungsgenerator von an sich üblicher Bauform zugeführt werden.

Erst zum Zeitpunkt t2 wird das Aktivierungssignal EN auf den hohen Signalpegel umgeschaltet. Dadurch werden die Sperrstufen T17, T27 leitend gesteuert, d.h. die über die Inverter G1, G2 geführten Logiksignale S1, S2 können jetzt an die erste und die zweite Schaltstufe I13, T15 bzw. I23, T25 gelangen. Im vorliegenden Beispiel liegt am Ausgang des Inverters G1 der ersten Steuerstufe 11 ein hoher Signalpegel an, weil das zugehörige erste Logiksignal 1 einen niedrigen Signalpegel aufweist. Umgekehrt liefert der Inverter G2 der zweiten Steuerstufe 21 ausgangsseitig einen niedrigen Signalpegel. Am Basisanschluß des Schalterelements T15 liegt dann ein hoher Signalpegel an. Dadurch bleibt das Schalterelement T15 weiterhin gesperrt, da der Verlauf des Steuersignals UTR derart abgestimmt ist, daß sein Wert den hohen Signalpegel nicht überschreitet. Über die Sperrstufe 27 der zweiten Steuerstufe 21 wird dagegen der Strom der dritten Konstantstromquelle I23 der zweiten Schaltstufe abgeleitet. Das Potential am Basisanschluß des Schalterelements T25 folgt über die leitende Sperrstufe T27 dem Potential am Ausgang des Inverters G2. Damit wird das Schalterelement T25 leitend, das Steuersignal UTR gelangt vom Steuersignaleingang 22 an den Verbindungspunkt 20 und damit an den Basisanschluß des Steuerelements T21 der zweiten Steuerstufe 21. Mit Zunahme des Wertes des Steuersignals UTR kann dieses das Steuerelement T21 einen leitenden Zustand überführen. Dieser Zustand wird in dem in Fig. 4 beispielhaft wiedergegebenen Verlauf zum Zeitpunkt t3 erreicht.

Vom Zeitpunkt t2 an bilden die Steuerelemente T11, T21 einen Differenzverstärker mit der Referenzstromquelle Iref als gemeinsamer Emitterstromquelle. Zwischen den Zeitpunkten t2 und t3 verharrt dieser Differenzverstärker noch in dem Zustand, daß einer seiner Zweige vollständig leitend und der andere vollständig gesperrt ist. Zum Zeitpunkt t3 wechselt dieser Differenzverstärker jedoch in seinen linearen Aussteuerungsbereich über, der auch durch die vorzugsweise einander gleichen Emitterwiderstände R1, R2 beeinflußt wird. Vom Zeitpunkt t3 an beginnt mit weiterer Erhöhung des Wertes des Steuersignals UTR das Steuerelement T21 mehr und mehr einen Strom zu führen, um dessen Betrag aufgrund des konstanten Stromes der Referenzstromquelle Iref der Strom durch das Steuerelement T11 der ersten Steuerstufe 11 vermindert wird. Entsprechend den sich nun stetig ändernden Strömen in den Steuerelementen T11, T21 werden über die Eingangszweige T12, T22 die erste steuerbare Stromquelle I1 allmählich unwirksam und die zweite steuerbare Stromquelle I2 allmählich wirksam geschaltet. Dabei verändern sich in gleichem Sinne auch die Halteströme in den Haltestromzweigen T14 und T24. Jedoch hat diese Änderung der Halteströme auf die bistabilen Stufen der Steuerstufen 11, 21 noch keinen wesentlichen Einfluß, da über das weiterhin leitende Potentialschiebeelement T16 und die erste Konstantstromquelle 11 der ersten bistabilen Stufe das Potential am Verbindungspunkt 10 zunächst weiterhin konstant bleibt und die Spannung am Verbindungspunkt 20 durch das Steuersignal UTR bestimmt wird. Dies gewährleistet, daß während des mit dem Zeitpunkt t3 für die steuerbaren Stromquellen I1, I2 beginnenden Übergangsintervalls die Umsteuerung der angeschlossenen Signalpfade präzise durch das Steuersignal UTR bestimmt wird.

Zum Zeitpunkt t4 erreicht der Wert der Spannung am Verbindungspunkt 20 durch das Steuersignal UTR den Wert der Spannung am Verbindungspunkt 10. Damit sind die Spannungen an den Basisanschlüssen der Steuerelemente T11, T21 gleich und somit auch die Ströme in den steuerbaren Stromquellen I1, I2. Mit weiter ansteigendem Wert des Steuersignals UTR wird der Strom in der zweiten steuerbaren Stromquelle I2 weiter vergrößert; entsprechend verringert sich der Strom in der ersten steuerbaren Stromquelle I1. Auch jetzt erfahren die Halteströme in den Haltestromzweigen T14, T24 die entsprechenden Änderungen. Dabei wird das Potentialschiebeelement T26 allmählich leitend; der über das Potentialschiebeelement T24 jetzt von der ersten Konstantstromquelle I21 der zweiten bistabilen Stufe geführte Strom kann jedoch, soweit er noch nicht aus dem Haltestromzweig T24 geliefert werden kann, über das Schalterelement T25 nachgeführt werden. Das Steuerelement T21 wird daher zunächst nicht beeinflußt.

Zum Zeitpunkt t5 unterschreitet der abnehmende Haltestrom aus dem Haltestromzweig T14 der ersten Steuerstufe 11 den Wert des von der zweiten Konstantstromquelle I12 der ersten bistabilen Stufe gelieferten Stromes. Daher wird nun der Basisanschluß des Steuerelements T11 über die zweite Konstantstromquelle I12 der ersten bistabilen Stufe auf das zweite Bezugspotential (Masse) gesteuert, womit das Steuerelement T11 sicher gesperrt wird. Damit fließt auch im Eingangszweig T12 der ersten steuerbaren Stromquelle I1 kein Strom mehr; die erste steuerbare Stromquelle I1 und der von ihr gespeiste erste Signalpfad sind damit unwirksam geschaltet. Der Strom aus der Referenzstromquelle Iref wird nun vollständig vom Steuerelement T21 der zweiten Steuerstufe 21 übernommen. Ein weiteres Ansteigen des Wertes des Steuersignals UTR über den Zeitpunkt t5 hinaus führt daher nicht zu einer weiteren Erhöhung des Stromes der zweiten steuerbaren Stromquelle I2.

Zum Zeitpunkt t6 wird daher der rampenförmige Anstieg des Steuersignals UTR beendet und gleichzeitig das Aktivierungssignal EN auf niedrigen Signalpegel zurückgeschaltet. Dadurch sinkt die Spannung am Verbindungspunkt 20 auf den Wert ab, auf den sie durch den nun durch den Haltestromzweig T24 fließenden Haltestrom geklemmt wird, der über die Konstantstromquellen I21, I22 der zweiten bistabilen Stufe unter Einbeziehung des Potentialschiebeelements T26 und über den Basisanschluß des Steuerelements T21 abfließt. Die Spannung am Verbindungspunkt 20 stellt sich damit auf den Wert ein, der durch das erste Bezugspotential Uref, erhöht im wesentlichen durch die Spannung am Potentialschiebeelement T26, bestimmt wird. Dieser Zustand bleibt erhalten auch nach Wegfall eines Stromes durch das Schalterelement T25 nach Absinken des Spannungswertes des Steuersignals UTR bzw. nach Abschalten der Schalterelemente T15, T25 durch das Aktivierungssignal EN über die Sperrstufen T17, T27. Auch das Steuerelement T11 des ersten analogen Multiplexerzweiges bleibt in seinem gesperrten Zustand, den es bis zum Zeitpunkt T6 erreicht hatte.

In Fig. 4a ist bis zum Zeitpunkt t7 das Steuersignal UTR wieder auf den Wert abgesunken, den es vor dem Zeitpunkt t1 inne hatte. Damit ist der Übergang von einem Signalpfad auf einen anderen zum Zeitpunkt t7 endgültig abgeschlossen; es kann sich ein weiterer Übergang anschließen. Gemäß dem Vorgeschriebenen wird in Anlehnung an die zeitlichen Verläufe der Ströme in den steuerbaren Stromquellen der Abschnitt zwischen den Zeitpunkten t3 und t5 als Übergangsintervall, der Zeitpunkt t5 somit als Ablauf des Übergangsintervalls bezeichnet. Die Zeiträume vor dem Zeitpunkt t2 und nach dem Zeitpunkt t6, in denen bedingt durch den Verlauf des Aktivierungssignals EN kein Übergang stattfindet, können somit als außerhalb des Übergangsintervalls liegend angesehen werden.

Beim beschriebenen Ausführungsbeispiel der Erfindung wird durch die dargestellte, zeitlineare Änderung des Steuersignals UTR und hinreichend groß dimensionierten Emitterwiderständen R1, R2 sichergestellt, daß die Ströme in den steuerbaren Stromquellen I1, I2 im Übergangsintervall auch zeitlineare Änderungen durchlaufen. Diese Verläufe können in verschiedener Weise abgewandelt werden. So zeigt zunächst Fig. 5 einen Fall mit ebenfalls rampenförmigem Steuersignal UTR, das sich von demjenigen aus Fig. 4 lediglich dadurch unterscheidet, daß es im Ruhezustand einen hohen Signalpegel annimmt, der im Intervall zwischen den Zeitpunkten t1 und t2 rasch auf einen Minimalwert abfällt, um danach bis zum Zeitpunkt t6 zeitlinear anzusteigen. Diese Abwandlung der Erfindung kann den Vorteil haben, daß das Zeitintervall zwischen den Zeitpunkten t1 und t2 zur Unterdrückung von Nadelimpulsen genutzt werden kann, die durch Gatterlaufzeiten in der Datenübertragungseinrichtung entstehen können. Das Aktivierungssignal EN kann dann während der gesamten Anstiegszeit des Steuersignals UTR wirksam sein, wobei diese Anstiegszeit im Gegensatz zu Fig. 4 das Zeitintervall zwischen den Zeitpunkten t2 und t6 ausfüllt. Ein weiterer Vorteil dieser Abwandlung ist die Möglichkeit, den Aufwand zur Erzeugung des Aktivierungssignals EN zu verringern und die Zeitdauer des rampenförmigen Anstiegs des Steuersignals UTR besser für den Überblendvorgang, d.h. den Übergang zwischen zwei Signalpfaden, nutzen zu können.

Anstelle zeitlinearer Änderung des Steuersignals UTR im Übergangsintervall kann hier auch ein verzerrter Verlauf mit variierender Steigung gewählt werden. Damit und mit einer geeigneten Dimensionierung der Emitterwiderstände R1, R2 kann für spezielle Anwendungen ein nichtlinearer Stromübergang von einem Signalpfad auf einen anderen erzielt werden.

In einem Wiedergabegerät für ein Audiosignal können die Einstellorgane für Lautstärke, Balance und Ausblendung auf mehrere Operationsverstärker der in Fig. 1 dargestellten Art verteilt sein. Dadurch kann die Notwendigkeit entstehen, die Einstellung der Signalpfade der einzelnen Operationsverstärker zugleich verändern zu können. Bei der erfindungsgemäßen Schaltungsanordnung wird dafür nur ein einziges Steuersignal UTR und damit auch nur ein einziger Generator zur Erzeugung eines solchen Steuersignals UTR benötigt. Vorzugsweise kann aber für jeden der Operationsverstärker in einem solchen Gerät ein gesondertes Aktivierungssignal EN erzeugt werden, welches mit den - "zentral" vorgegebenen - Rampenverläufen des Steuersignals UTR synchronisiert werden muß.

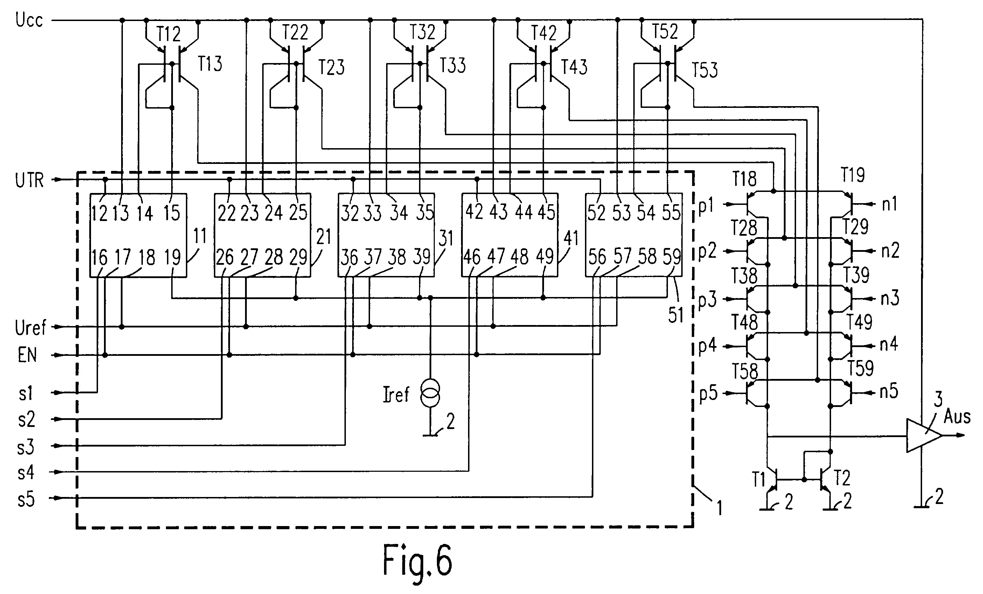

Fig. 6 zeigt ein weiteres Ausführungsbeispiel einer erfindungsgemäßen Schaltungsanordnung, in dem die Ansteuerschaltung 1 insgesamt fünf Steuerstufen 11, 21, 31, 41, 51 aufweist. Dabei sind die dritte, vierte und fünfte Steuerstufe 31, 41 bzw. 51 mit der ersten bzw. der zweiten Steuerstufe 11 bzw. 21 identisch aufgebaut. Jede Steuerstufe ist entsprechend Fig. 3 mit je einer der steuerbaren Stromquellen I1, I2, I3, I4 bzw. I5 verbunden, wobei die dritte, vierte und fünfte steuerbare Stromquelle I3, I4 bzw. I5 entsprechend der ersten bzw. zweiten steuerbaren Stromquelle I1 bzw. I2 je einen Eingangszweig T32, T42 bzw. T52 und je einen Ausgangszweig T33, T43 bzw. T53 aufweist, die ebenfalls je eine Stromspiegelanordnung bilden. Signalpfade und gemeinsame Ausgangsstufe 3 stimmen mit Fig. 1 überein.

In Fig. 6 sind die Steuerstufen 11, 21, 31, 41, 51 lediglich blockschematisch dargestellt, da sie entsprechend Fig. 3 aufgebaut sind. Lediglich ihre Anschlüsse, die ebenfalls einander entsprechen, sind in Fig. 6 einzeln bezeichnet. So sind von allen Steuerstufen 11, 21, 31, 41, 51 die Steuersignaleingänge 12, 22, 32, 42 bzw. 52 miteinander zum gemeinsamen Zuführen des Steuersignals UTR verbunden. Auch die Versorgungsspannung Ucc ist jeder der Steuerstufen 11, 21, 31, 41 bzw. 51 über je einen Versorgungsspannungsanschluß 13, 23, 33, 43 bzw. 53 zugeleitet. Die Referenzstromquelle Iref ist außer mit der ersten und der zweiten Steuerstufe 11 bzw. 21 auch mit den übrigen Steuerstufen 31, 41, 51 über entsprechende Anschlüsse 39, 49 bzw. 59 verbunden, und das erste Bezugspotential Uref gelangt zu den Steuerstufen 31, 41, 51 über Anschlüsse 38, 48 bzw. 58. Für alle Steuerstufen 11 bis 51 gemeinsam ist außerdem das Aktivierungssignal EN, welches der dritten, vierten bzw. fünften Steuerstufe 31, 41 bzw. 51 über Aktivierungssignaleingänge 37, 47 bzw. 57 zugeleitet wird. Außerdem weisen die drei in Fig. 6 gegenüber Fig. 3 zusätzlichen Steuerstufen 31, 41, 51 je einen Haltestrom-Steueranschluß 34, 44 bzw. 54, einen Ausgang 35 eines von der jeweiligen Steuerstufe umfaßten Multiplexerzweiges (nicht explizid dargestellt) sowie je einen Logiksignaleingang 36, 46 bzw. 56 auf. Letzteren werden die Logiksignale s3, s4 bzw. s5 zugeleitet.

Es bedarf keiner gesonderten Erwähnung, daß in Fig. 6 eine Überblendung von einer beliebigen der Steuerstufen auf eine andere beliebige Steuerstufe je nach Wahl durch die Logiksignale s1 bis s5 möglich ist.

In der Praxis sind auch Anordnung mit einer wesentlich höheren Anzahl von Signalpfaden ohne Schwierigkeiten herstellbar.

Die erfindungsgemäße Schaltungsanordnung stellt eine ökonomische Möglichkeit dar, die bestehenden Nachteile der Schaltungen nach dem Stand der Technik mit nur geringem Schaltungsaufwand zu beseitigen. Die zusätzlich erforderlichen Schaltungsteile, d.h. die Ansteuerschaltung mit den Steuerstufen, schließen sich unmittelbar an die ohnehin benötigten steuerbaren Stromquellen an und erweitern diese in Betrachtung ihrer Kombination mit den Steuerschaltungen zu Speicherschaltungen mit steuerbarem Übergangsverhalten beim Übergang zwischen zwei Signalpfaden. Ohne zusätzlichen Aufwand können dabei Störungen in den Logiksignalen. insbesondere Nadelimpulse, unterdrückt werden.

## Patentansprüche

1. Schaltungsanordnung mit wenigstens zwei Signalpfaden, die durch je eine steuerbare Stromquelle zu speisen und durch jeweils eine der steuerbaren Stromquellen auswählende Logiksignale wechselweise wirksam zu schalten sind, wobei beim Übergang von einem Signalpfad auf einen anderen während eines Übergangsintervalls die steuerbaren Stromquellen der betreffenden zwei Signalpfade durch ein zeitlich stetig sich änderndes Steuersignal derart zu steuern sind, daß sich von diesen beiden steuerbaren Stromquellen abgebbare Ströme stetig und gegensinnig ändern,
gekennzeichnet durch eine Ansteuerschaltung (1), die zu jedem der Signalpfade (T18,T19; T28,T29; T38,T39; T48,T49; T58,T59) eine Steuerstufe (11; 21; 31; 41; 51) umfaßt, wobei jede der Steuerstufen (11; 21; 31; 41; 51) enthält:
- einen analogen Multiplexerzweig (T11,R1; T21,R2), über den ein die dem betreffenden Signalpfad (T18,T19; T28,T29; T38,T39; T48,T49; T58,T59) zugehörige steuerbare Stromquelle (I1; I2; I3; I4; I5) wirksam schaltender Strom aus einer von der Ansteuerschaltung (1) umfaßten, den Multiplexerzweigen (T11,R1 T21,R2) aller Steuerstufen (11; 21; 31; 41; 51) gemeinsamen Referenzstromquelle (Iref) leitbar ist,
- eine bistabile Stufe (T14,T16,I11,I12; T24,T26,I21,I22) zum stetigen Steuern des Stromes im Multiplexerzweig (T11,R1; T21,R2) nach Maßgabe des Steuersignals (UTR) und zum Speichern des zum Ende des Übergangsintervalls (t3 - t5) erreichten Betriebszustandes des Multiplexerzweiges (T11,R1; T21,R2) außerhalb des Übergangsintervalls (t3 - t5),
- sowie eine Schaltstufe (I13,T15; I23,T25) zum Aufschalten des Steuersignals (UTR) während des Übergangsintervalls (t3 - t5) mittels der Logiksignale (s1; s2; s3; s4; s5) über die bistabile Stufe (T14,T16,I11,I12; T24,T26,I21,I22) auf den Multiplexerzweig (T11,R1; T21,R2) desjenigen Signalpfades (T18,T19; T28,T29; T38,T39; T48,T49; bzw. T58,T59), der nach Ablauf (t5) des Übergangsintervalls t3 bis t5) nach Maßgabe der Logiksignale (s1; s2; s3; s4; s5) wirksam zu schalten ist.

2. Schaltungsanordnung nach Anspruch 1,
dadurch gekennzeichnet, daß jede der Steuerstufen (11; 21; 31; 41; 51) eine Sperrstufe (T17; T27;) umfaßt und daß allen Sperrstufen (T17; T27) ein gemeinsames Aktivierungssignal (EN) zuleitbar ist, durch das sie während des Übergangsintervalls (t3 - t5) zum Zuführen der Logiksignale (s1; s2; s3; s4; s5) an die Schaltstufen I13,T15; I23,T25) und außerhalb (t6 - t2) des Übergangsintervalls zum Unterbrechen der Zufuhr der Logiksignale (s1; s2; s3; s4; s5) umsteuerbar sind.

3. Schaltungsanordnung nach Anspruch 1 oder 2,
dadurch gekennzeichnet, daß mit jeder Steuerstufe (11; 21; 31; 41; bzw. 51) eines der Logiksignale (s1; s2; s3; s4; bzw. s5) zugeordnet ist und daß dieses Logiksignal (s1; s2: s3: s4; bzw. s5) einen ersten Signalpegel annimmt, wenn der zugehörige Signalpfad (T18,T19; T28,T29; T38,T39; T48,T49; bzw. T58,T59) nach Ablauf des nächsten Übergangsintervalls (t3 - t5) wirksam geschaltet sein soll, während gleichzeitig alle übrigen Logiksignale einen zweiten Signalpegel annehmen.

4. Schaltungsanordnung nach Anspruch 3,
dadurch gekennzeichnet, daß jede der Steuerstufen (11; 21; 31; 41; 51) einen Inverter (G1; G2) umfaßt zum Zuführen des zugeordneten Logiksignals (s1; s2; s3; s4; bzw. s5) an die zugehörige Schaltstufe (I13,T15; bzw. I23,T25) bzw. Sperrstufe (T17; bzw. T27).

5. Schaltungsanordnung nach einem der vorhergehenden Ansprüche,
dadurch gekennzeichnet, daß die steuerbaren Stromquellen (I1; I2; I3; I4; I5) je eine Stromspiegelanordnung (T12,T13; T22,T23; T32,T33; T42,T43; T52,T53) umfassen, deren Eingangszweig (T12; T22; T32; T42; T52) der die steuerbare Stromquelle I1; I2; I3; I4; I5) wirksam schaltende Strom aus dem zugehörigen Multiplexerzweig (T11,R1; T21,R2) zuführbar ist und deren Ausgangszweig (T13; T23; T33; T43; T53) den zugehörigen Signalpfad speist.

6. Schaltungsanordnung nach Anspruch 5,
dadurch gekennzeichnet, daß die bistabilen Stufen (I11,I12,T14,T16; I21,I22,T24,T26) je einen durch den Eingangszweig (T12; T22; T32; T42; T52) der zugehörigen steuerbaren Stromquelle (I1; I2; I3; I4; I5) steuerbaren Haltestromzweig (T14; T24) umfassen, dem im Fall des Wirksamschaltens des zugehörigen Signalpfades (T18,T19; T28,T29; T38,T39; T48,T49; T58,T59) ein Haltestrom zum Speichern des dementsprechenden Betriebszustandes des zugehörigen Multiplexerzweiges (T11,R1; T21,R2) entnehmbar ist.

7. Schaltungsanordnung nach Anspruch 6,
dadurch gekennzeichnet, daß die bistabilen Stufen (I11,I12,T14,T16; I21,I22,T24,T26) ferner enthalten: Je eine erste Konstantstromquelle (I11; I21) die einerseits an ein erstes Bezugspotential (Uref) und andererseits über ein Potentialschiebeelement (T16; T26) an einen Verbindungspunkt (10; 20) mit dem Haltestromzweig (T14: T24) angeschlossen ist, und eine zweite Konstantstromquelle I12; I22), die einerseits an den Verbindungspunkt (10; 20) und andererseits an ein zweites Bezugspotential (2) angeschlossen ist.

8. Schaltungsanordnung nach Anspruch 7,
dadurch gekennzeichnet, daß das erste Bezugspotential (Uref) höher ist als das zweite Bezugspotential (2).

9. Schaltungsanordnung nach einem der vorhergehenden Ansprüche,
dadurch gekennzeichnet, daß die Multiplexerzweige je ein Steuerelement (T11; T21) enthalten, welches einen Steueranschluß aufweist, der mit der zugehörigen bistabilen Stufe I11,I12,T14,T16; bzw. I21,I22,T24,T26) verbunden ist.

10. Schaltungsanordnung nach Anspruch 9 in Verbindung mit einem der Ansprüche 7 oder 8,
dadurch gekennzeichnet, daß das Steuerelement (T11; T21) von einem Transistor gebildet ist, dessen Steueranschluß mit dem Verbindungspunkt (10; 20) in der zugehörigen bistabilen Stufe I11,I12,T14,T16; I21,I22,T24,T26) verknüpft ist.

11. Schaltungsanordnung nach Anspruch 10 oder nach Anspruch 9 in Verbindung mit einem der Ansprüche 7 oder 8,
dadurch gekennzeichnet, daß die Schaltstufen (I13,T15; I23,T25) je ein Schalterelement (T15; T25) enthalten, das einen Steueranschluß aufweist, dem das zugeordnete Logiksignal (s1; s2; s3; s4; bzw. s5) zuleitbar ist, in welchem Fall das Steuersignal (UTR) durch das Schalterelement (T15; T25) dem Verbindungspunkt (10; 20) der zugehörigen bistabilen Stufe aufgeschaltet wird.

12. Schaltungsanordnung nach einem der vorhergehenden Ansprüche,
dadurch gekennzeichnet, daß das Steuersignal (UTR) während des Übergangsintervalls (t3 - t5) einen wenigstens nahezu rampenförmigen zeitlichen Verlauf aufweist.

13. Schaltungsanordnung nach einem der vorhergehenden Ansprüche,
dadurch gekennzeichnet, daß die Signalpfade (T18,T19; T28,T29; T38,T39; T48,T49; T58,T59) je eine von der zugehörigen steuerbaren Stromquelle zu speisende Differenzverstärkerstufe umfassen, die nur wirksam geschaltet ist, wenn ihr von der steuerbaren Stromquelle (I1; I2; I3; I4; I5) ein Strom zugeführt wird.

14. Schaltungsanordnung nach Anspruch 13,
dadurch gekennzeichnet, daß alle Differenzverstärkerstufen (T18,T19; T28,T29; T38,T39; T48,T49; T58,T59) ausgangsseitig mit einer gemeinsamen Ausgangsstufe (3) verbunden sind.

15. Signalsteller,
gekennzeichnet durch eine Schaltungsanordnung nach einem der vorhergehenden Ansprüche.

16. Lautstärke- und/oder Klangeinsteller für ein Audiosignal,
gekennzeichnet durch einen Signalsteller nach Anspruch 15.

17. Wiedergabegerät für ein Audiosignal,
gekennzeichnet durch einen Lautstärke- und/oder Klangeinsteller nach Anspruch 16.
